(19) Europäisches Patentamt
European Patent Office
Office européen des brevets

(11) **EP 4 030 880 A1**

(12) **EUROPEAN PATENT APPLICATION**
published in accordance with Art. 153(4) EPC

(43) Date of publication:
**20.07.2022 Bulletin 2022/29**

(21) Application number: **20862795.0**

(22) Date of filing: **24.08.2020**

(51) International Patent Classification (IPC):
**H05K 9/00** (2006.01)    **B32B 7/025** (2019.01)

(52) Cooperative Patent Classification (CPC):
**B32B 7/025; H05K 9/00**

(86) International application number:
**PCT/JP2020/031879**

(87) International publication number:
**WO 2021/049284 (18.03.2021 Gazette 2021/11)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **13.09.2019   JP 2019167057**

(71) Applicant: **NITTO DENKO CORPORATION**
**Ibaraki-shi**
**Osaka 567-8680 (JP)**

(72) Inventors:
- **NAKANISHI Yosuke**
  **Ibaraki-shi, Osaka 567-8680 (JP)**
- **NAGAOKA Naoki**
  **Ibaraki-shi, Osaka 567-8680 (JP)**
- **MACHINAGA Hironobu**
  **Ibaraki-shi, Osaka 567-8680 (JP)**

(74) Representative: **Grünecker Patent- und
Rechtsanwälte
PartG mbB
Leopoldstraße 4
80802 München (DE)**

(54) **IMPEDANCE MATCHING FILM AND RADIO WAVE ABSORBER**

(57)    An impedance matching film 10a includes a plurality of openings 11 regularly arranged along a principal surface 10f of the impedance matching film 10a. In the impedance matching film 10a, a value p/t obtained by dividing a specific resistance p of a material of the impedance matching film 10a by a thickness t of the impedance matching film 10a is 1 to 300 $\Omega/\square$.

FIG. 1B

**Description**

TECHNICAL FIELD

The present invention relates to an impedance matching film and a radio wave absorber.

BACKGROUND ART

A technique that is for impedance matching by means of a predetermined film and by which impedance of a front surface of a radio wave absorber is matched to a characteristic impedance of air has been conventionally known. Meanwhile, an effort has been made to provide a transparent radio wave absorber.

For example, Patent Literature 1 describes a radio wave absorber in which all component layers are transparent or semi-transparent. In this radio wave absorber, a whole-surface conductor layer, a first dielectric layer, a linear pattern resistance layer, a second dielectric layer, and a pattern layer are stacked in this order. The pattern layer being the uppermost layer of this radio wave absorber can favorably receive an electromagnetic wave. Since the pattern layer and the second dielectric layer are in contact with each other, a large portion of the electromagnetic wave received by the pattern layer leaks to the second dielectric layer. Since the second dielectric layer and the linear pattern layer are in contact with each other, the linear pattern layer can efficiently convert the electromagnetic wave leaking to the second dielectric layer into heat. A highly resistive conductor having a volume resistivity of $1.0 \times 10^{-4}$ Ωcm or more and $1.0 \times 10^{-1}$ Ωcm or less forms the linear pattern resistance layer.

CITATION LIST

Patent Literature

Patent Literature 1: JP 2006-179671 A

SUMMARY OF INVENTION

Technical Problem

In the radio wave absorber described in Patent Literature 1, the linear pattern layer is for efficiently converting an electromagnetic wave leaking to the second dielectric layer into heat, and Patent Literature 1 does not describe impedance matching by means of the linear pattern layer.

Meanwhile, it is expected that impedance matching films having transparency will be needed in sensing using a sensor disposed around a headlight and a windshield. Moreover, it is expected that impedance matching films having transparency and being advantageous in noise reduction will be needed in a wide range of technical fields, such as fields of the 5th generation mobile communication system (5G) and the Internet of things (IoT). In view of these circumstances, the present invention provides a new impedance matching film having transparency.

Solution to Problem

The present invention provides an impedance matching film, including: a plurality of openings regularly arranged along a principal surface of the impedance matching film, wherein

a value obtained by dividing a specific resistance of a material of the impedance matching film by a thickness of the impedance matching film is 1 to 300 Ω/□.

The present invention also provides a radio wave absorber, including:

the above impedance matching film;
a reflector that reflects a radio wave; and
a dielectric layer disposed between the impedance matching film and the reflector in a thickness direction of the impedance matching film.

Advantageous Effects of Invention

The above impedance matching film is a new impedance matching film having transparency.

BRIEF DESCRIPTION OF DRAWINGS

FIG. 1A is a plan view showing an example of an impedance matching film according to the present invention.
FIG. 1B is a cross-sectional view of the impedance matching film taken along a line IB-IB in FIG. 1A.
FIG. 2A is a plan view showing another example of the impedance matching film according to the present invention.
FIG. 2B is a plan view showing yet another example of the impedance matching film according to the present invention.
FIG. 2C is a plan view showing yet another example of the impedance matching film according to the present invention.
FIG. 3A is a cross-sectional view showing an example of a radio wave absorber according to the present invention.
FIG. 3B is a cross-sectional view showing a variation of the radio wave absorber according to the present invention.
FIG. 3C is a cross-sectional view showing another variation of the radio wave absorber according to the present invention.
FIG. 4 is a cross-sectional view showing another example of the radio wave absorber according to the present invention.

DESCRIPTION OF EMBODIMENTS

A plurality of openings of an impedance matching film are advantageous in view of imparting transparency to an impedance matching film. Moreover, a plurality of openings regularly arranged along a principal surface of an impedance matching film is advantageous in view of reducing spatial variation in transparency of the impedance matching film. Studies by the present inventors revealed that the description in Patent Literature 1 was insufficient to produce such an impedance matching film. Therefore, as a result of intensive studies, the present inventors newly found that adjusting a value obtained by dividing the specific resistance of the material of an impedance matching film by the thickness of the impedance matching film within a given range is advantageous in view of achieving both desirable impedance matching and high transparency. The present inventors have invented the impedance matching film according to the present invention on the basis of this new finding. The term "transparency" as used herein means transparency to visible light unless otherwise described.

Hereinafter, embodiments of the present invention will be described with reference to the drawings. The present invention is not limited to the following embodiments.

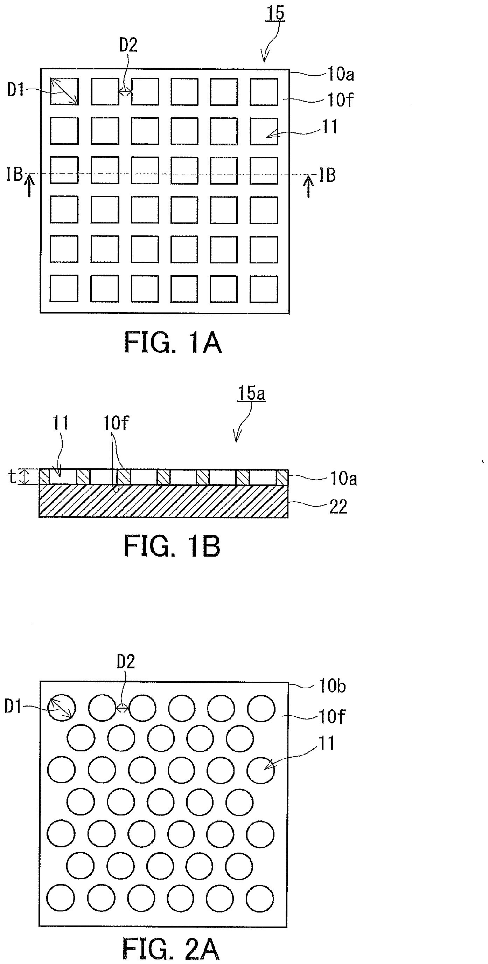

As shown in FIGS. 1A and 1B, an impedance matching film 10a includes a plurality of openings 11. Because of this, the impedance matching film 10a has transparency. The plurality of openings 11 are regularly arranged along a principal surface 10f of the impedance matching film 10a. Herein, the principal surface 10f refers to a front surface and a back surface positioned apart from each other in a thickness direction of the impedance matching film 10a. Each opening 11 is typically formed as a through hole in the impedance matching film 10a. In the impedance matching film 10a, a value p/t obtained by dividing a specific resistance p $[\Omega \cdot m]$ of a material of the impedance matching film 10a by a thickness t [m] of the impedance matching film 10a is 1 to 300 $\Omega/\square$. It should be noted that the dimension of the value p/t is $\Omega$, but the unit of the value p/t is expressed as $\Omega/\square$ to distinguish the value from an electrical resistance. The impedance matching film 10a having a value p/t of 1 to 300 $\Omega/\square$ is advantageous in terms of arranging the plurality of openings 11 so that the impedance matching film 10a will have desirable transparency and perform desirable impedance matching.

The specific resistance p of the material of the impedance matching film 10a can be determined, for example, by measuring the electrical resistance and size of a piece taken from the impedance matching film 10a and having a given size. The thickness t of the impedance matching film 10a can be determined, for example, by observing a cross-section of the impedance matching film 10a using a transmission electron microscope (TEM).

In the impedance matching film 10a, p/t may be 250 $\Omega/\square$ or less, 200 $\Omega/\square$ or less, or less than 200 $\Omega/\square$. This makes it easy to arrange the plurality of openings 11 so that the impedance matching film 10a will have high transparency and to perform desirable impedance matching.

In the impedance matching film 10a, p/t may be 2 $\Omega/\square$ or more, 3 $\Omega/\square$ or more, or 4 $\Omega/\square$ or more. This makes it easy to perform desirable impedance matching by means of the impedance matching film 10a.

A maximum size D1 of the opening 11 on the principal surface 10f is not limited to a particular value. The maximum size D1 is, for example, $7.5 \times 10^4$ $\mu$m or less. This makes it easy to perform desirable impedance matching by means of the impedance matching film 10a. For example, a radio wave absorber produced using the impedance matching film 10a is likely to exhibit high radio wave absorption performance for a radio wave having a desirable frequency. As shown in FIG. 1A, for example, the opening 11 is in the shape of a quadrangle in plan view, the maximum size D1 can correspond to the length of a diagonal line of the quadrangle.

The maximum size D1 may be $5.0 \times 10^4$ $\mu$m or less, $0.5 \times 10^4$ $\mu$m or less, $0.1 \times 10^4$ $\mu$m or less, or $0.03 \times 10^4$ $\mu$m or less.

The lower limit of the maximum size D1 is not limited to a particular value. The maximum size D1 is, for example, 1 $\mu$m or more, and may be 5 $\mu$m or more or 10 $\mu$m or more. This makes it easy to produce the impedance matching film 10.

In the impedance matching film 10a, a minimum D2 of a distance between the openings 11 is not limited to a particular value. The minimum D2 is, for example, 0.1 to 650 $\mu$m. In this case, the impedance matching film 10a more reliably has transparency and desirable impedance matching can be performed by means of the impedance matching film 10a. For example, a radio wave absorber produced using the impedance matching film 10a is likely to exhibit high radio wave absorption performance for a radio wave having a desirable frequency.

The minimum D2 may be 0.3 $\mu$m or more or 0.5 $\mu$m or more. The minimum D2 may be 640 $\mu$m or less, 600 $\mu$m or less, 500 $\mu$m or less, 400 $\mu$m or less, or 300 $\mu$m or less.

The thickness t of the impedance matching film 10a is not limited to a particular value as long as p/t is 1 to 300 $\Omega/\square$. The thickness t of the impedance matching film 10a is, for example, 5 to 500 nm. In this case, it is easy to reduce warping of the impedance matching film 10a, and a crack is unlikely to happen in the impedance matching film 10a. Moreover, it is easy to suppress a change in the properties of the impedance matching film 10a placed in a given environment.

The thickness t of the impedance matching film 10a may be 10 nm or more or 15 nm or more. In this case, it is easy to suppress a change in the properties of the impedance matching film 10a placed in a given environment. The thickness t of the impedance matching film 10a may be 450 nm or less or 400 nm or less. In this case, warping of the impedance matching film 10a can be reduced more reliably.

The specific resistance p of the material of the impedance matching film 10a is not limited to a particular value as long as p/t is 1 to 300 $\Omega/\square$. p is, for example, $5 \times 10^{-6}$ to $2 \times 10^{-3}$ $\Omega \cdot$cm. In this case, the thickness t of the impedance matching film 10 is likely to be the desirable thickness when p/t is adjusted within the desirable range. As a result, it is easy to suppress a change in the properties of the impedance matching film 10a placed in a given environment. Additionally, it is easy to reduce warping of the impedance matching film 10a, and a crack is unlikely to happen in the impedance matching film 10a.

The specific resistance p of the material of the impedance matching film 10a may be, for example, $1 \times 10^{-5}$ $\Omega \cdot$cm or more or $5 \times 10^{-5}$ $\Omega \cdot$cm or more. This makes it easy to decrease the thickness t of the impedance matching film 10 and to reduce warping of the impedance matching film 10a. As a result, a crack is unlikely to happen in the impedance matching film 10a. The specific resistance p of the material of the impedance matching film 10a may be, for example, $1.8 \times 10^{-3}$ $\Omega \cdot$cm or less or $1.6 \times 10^{-3}$ $\Omega \cdot$cm or less. This makes it easy to increase the thickness t of the impedance matching film 10 and to suppress a change in the properties of the impedance matching film 10a placed in a given environment.

The arrangement of the plurality of openings 11 is not limited to a particular arrangement as long as the openings 11 are regularly arranged. For example, in the impedance matching film 10a, the plurality of openings 11 are arranged such that centers of the openings 11 make a square lattice on the principal surface 10f.

The shape of each opening 11 is not limited to a particular shape as long as the openings 11 are regularly arranged. For example, in the impedance matching film 10a, the plurality of openings 11 are each in a square shape in plan view.

An opening proportion of the openings 11 in the impedance matching film 10a is not limited to a particular value. The opening proportion of the openings 11 in the impedance matching film 10a is, for example, 50% or more, and may be 60% or more or 70% or more. The opening proportion of the openings 11 in the impedance matching film 10a is, for example, 99% or less, and may be 97% or less or 95% or less. The opening proportion of the openings 11 is a proportion Sa/(Sa + Sb) of an opening area Sa of the plurality of openings 11 of the impedance matching film 10a viewed in plan in the sum Sa + Sb of the opening area Sa of the plurality of openings 11 and an area Sb of a non-opening portion of the impedance matching film 10a viewed in plan.

The material of the impedance matching film 10a is not limited to a particular material as long as p/t can be adjusted to 1 to 300 $\Omega/\square$. The material of the impedance matching film 10a may be an inorganic material such as a metal, an alloy, or a metal oxide or may be an organic material such as an electrically conductive polymer or a carbon nanotube.

The impedance matching film 10a may be a film that has a uniform thickness and in which a plurality of through holes are formed or may be made of a fabric. Fibers of the fabric may be an organic material such as an electrically conductive polymer or a carbon nanotube or may be an inorganic material such as a metal or an alloy.

As shown in FIG. 1, the impedance matching film 10a may be formed, for example, on one principal surface of a substrate 22. In this case, the impedance matching film 10a can be provided in the form of an impedance matching film-attached film 15. The impedance matching film 10a may be provided alone without the substrate 22.

The substrate 22 plays a role, for example, as a support that supports the impedance matching film 10a. The impedance matching film 10a of the impedance matching film-attached film 15 can be produced, for example, by forming the plurality of openings 11 by laser processing, etching, or the like in an imperforate film formed on one principal surface of the substrate 22 by a film formation method such as sputtering. In some cases, the imperforate film to be formed into the impedance matching film 10a may be formed by a film formation method such as ion plating or coating (for example, bar coating).

The substrate 22 has a thickness of, for example, 10 to 150 $\mu$m and desirably has a thickness of 15 to 100 $\mu$m. In this case, the substrate 22 has low flexural rigidity, and occurrence of a wrinkle in the substrate 22 or deformation of the substrate 22 can be reduced at the time of formation of the impedance matching film 10a.

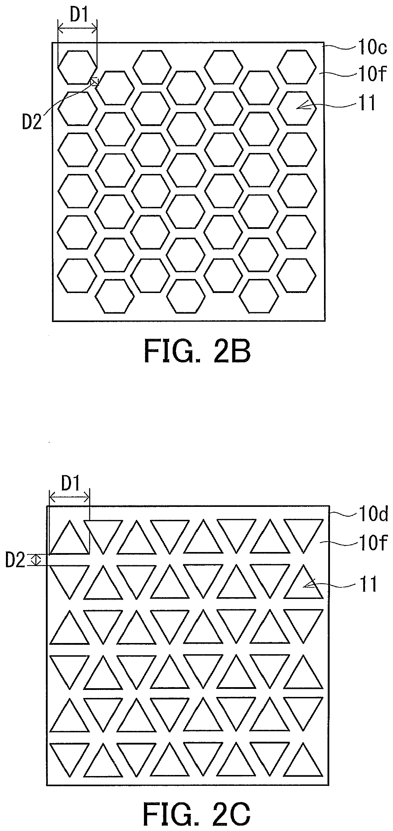

The impedance matching film 10a may be modified such that the plurality of openings 11 are arranged and have the shapes as shown by an impedance matching film 10b shown in FIG. 2A, an impedance matching film 10c shown in FIG. 2B, or an impedance matching film 10d shown in FIG. 2C. The impedance matching films 10b, 10c, and 10d are configured in the same manner as the impedance matching film 10a unless otherwise described. The components of the impedance matching films 10b, 10c, and 10d that are the same as or correspond to the components of the impedance matching film 10a are denoted by the same reference characters, and detailed descriptions of such components are omitted. The description given for the impedance matching film 10a can apply to the impedance matching films 10b, 10c, and 10d, unless there is technical inconsistency.

As shown in FIG. 2A, in the impedance matching film 10b, the plurality of openings 11 are each in a circular shape in plan view. Additionally, the plurality of openings 11 are arranged such that centers thereof make a parallelogram lattice on the principal surface 10f.

As shown in FIG. 2B, in the impedance matching film 10c, the plurality of openings 11 are each in a regular hexagonal shape in plan view. Additionally, the plurality of openings 11 are arranged such that centers thereof make a parallelogram lattice on the principal surface 10f.

As shown in FIG. 2C, in the impedance matching film 10c, the plurality of openings 11 are each in a regular triangular shape in plan view. Additionally, the plurality of regular triangular openings 11 having the same orientation are arranged such that centers of the openings 11 make a parallelogram lattice on the principal surface 10f. Herein, a center of gravity of a plane figure is regarded as a center of the opening having the shape of the plane figure.

The plurality of openings 11 may be in another polygonal shape, such as a rectangular shape, or an elliptical shape in plan view. The plurality of openings 11 may be arranged such that centers thereof make another plane lattice, such as a rectangular lattice, on the principal surface 10f. Herein, the term "plane lattice" refers to an array of points on a plane, the array being unchanged by parallel displacement in two independent directions over a constant distance each.

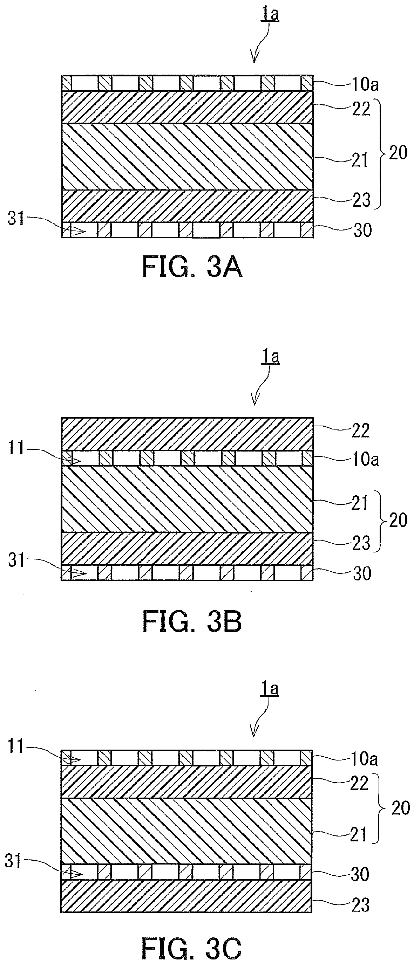

As shown in FIG. 3A, for example, a radio wave absorber 1a can be provided using the impedance matching film 10a. The radio wave absorber 1a includes the impedance matching film 10a, a reflector 30 that reflects a radio wave, and a dielectric layer 20. The dielectric layer 20 is disposed between the impedance matching film 10a and the reflector 30 in a thickness direction of the impedance matching film 10a.

The radio wave absorber 1a is, for example, a $\lambda/4$ radio wave absorber. The radio wave absorber 1a is designed to cause interference between a radio wave reflected by the surface of the impedance matching film 10a (front surface reflection) and a radio wave reflected by the reflector 30 (back surface reflection) upon incidence of a radio wave having a wavelength $\lambda_0$ to be absorbed on the radio wave absorber 1a. In the $\lambda/4$ radio wave absorber, the wavelength $\lambda_0$ of a radio wave to be absorbed is determined according to a thickness t of the dielectric layer and a relative permittivity $\varepsilon_r$ of the dielectric layer, as shown in the following equation (1). That is, a radio wave having a wavelength to be absorbed can be set by appropriately adjusting the relative permittivity and thickness of the dielectric layer. In the equation (1), sqrt($\varepsilon_r$) means a square root of the relative permittivity $\varepsilon_r$.

$$\lambda_0 = 4t \times \mathrm{sqrt}(\varepsilon_r) \qquad \text{Equation (1)}$$

In the radio wave absorber 1a, the maximum size D1 of the opening 11 is, for example, 1/4 or less of an absorption peak wavelength $\lambda$p. The absorption peak wavelength $\lambda$p is a radio wavelength at which an absolute value of a reflection amount measured for the radio wave absorber 1a according to Japanese Industrial Standards (JIS) R 1679: 2007 is largest. In other words, the absorption peak wavelength $\lambda$p is a radio wavelength at which a radio wave absorption amount of the radio wave absorber 1a is largest. The radio wave absorption amount is an absolute value of the reflection amount measured according to JIS R 1679: 2007. With this configuration, front surface reflection of a radio wave with the absorption peak wavelength $\lambda$p occurs properly on the radio wave absorber 1a, and the radio wave absorber 1a can favorably absorb the radio wave with the absorption peak wavelength $\lambda$p.

The radio wave absorber 1a is configured to perform, for example, impedance matching for a radio wave having a frequency of 1 GHz or more. As a result, the radio wave absorber 1a can effectively absorb a radio wave having a frequency of 1 GHz or more.

The frequency of a radio wave for which the radio wave absorber 1a performs impedance matching may be 1 GHz or more, 4 GHz or more, or 20 GHz or more. The frequency of a radio wave for which the radio wave absorber 1a performs impedance matching is, for example, 3000 GHz or less, and may be 300 GHz or less or 100 GHz or less.

The reflector 30 is not limited to a particular embodiment as long as the reflector 30 can reflect a radio wave to be absorbed. The reflector 30 is, for example, a transparent conductive film. In this case, the reflector 30 has transparency and the radio wave absorber 1a is likely to be entirely transparent. The material of the transparent conductive film may be an inorganic material such as a metal, an alloy, or a metal oxide or may be an organic material such as an electrically conductive polymer or a carbon nanotube.

The transparent conductive film has, for example, a plurality of openings 31 regularly arranged along a principal surface of the transparent conductive film. With this configuration, the reflector 30 can properly reflect a radio wave to be absorbed and is likely to have desirable transparency. The transparent conductive film may be an imperforate film.

When the reflector 30 has the plurality of openings 31, the impedance matching film 10a may be a film that has a uniform thickness and in which a plurality of through holes are formed or may be made of a fabric. Fibers of the fabric may be an organic material such as an electrically conductive polymer or a carbon nanotube or may be an inorganic material such as a metal or an alloy.

The shape of each opening 31 of the reflector 30 is not limited to a particular shape. Examples of the shape of each opening 31 in plan view may include a triangle, a quadrangle such as a square and a rectangle, a hexagon, other polygons, a circle, and an ellipse.

The arrangement of the plurality of openings 31 of the reflector 30 is not limited to a particular arrangement. The plurality of openings 31 may be arranged, for example, such that centers thereof make a plane lattice such as a square or parallelogram lattice.

The relative permittivity of the dielectric layer 20 is, for example, 2.0 to 20.0. In this case, the thickness of the dielectric layer 20 is easily adjusted, and so is the radio wave absorption performance of the radio wave absorber 1a. The relative permittivity of the dielectric layer 20 is, for example, a relative permittivity measured at 10 GHz by a cavity resonance method.

The dielectric layer 20 is formed of, for example, a given polymer. The dielectric layer 20 includes, for example, at least one polymer selected from the group consisting of ethylene-vinyl acetate copolymer, vinyl chloride resin, urethane resin, acrylic resin, acrylic urethane resin, polyethylene, polypropylene, silicone, polyethylene terephthalate, polyethylene naphthalate, polycarbonate, polyimide, and cycloolefin polymer. In this case, the thickness of the dielectric layer 20 is easily adjusted and the manufacturing cost of the radio wave absorber 1a can be maintained at a low level. The dielectric layer 20 can be produced, for example, by hot-pressing a given resin composition.

The dielectric layer 20 may be formed as a single layer or as a plurality of layers made of the same material or different materials. When the dielectric layer 20 includes n layers (n is an integer of two or greater), the relative permittivity of the dielectric layer 20 is determined, for example, as follows. The relative permittivity $\varepsilon_i$ of each layer is measured (i is an integer of one to n). Next, the relative permittivity $\varepsilon_i$ of each layer is multiplied by the proportion of the thickness ti of the layer in the total thickness T of the dielectric layer 20 to determine $\varepsilon_i \times (t_i/T)$. The relative permittivity of the dielectric layer 20 can be determined by adding the $\varepsilon_i \times (t_i/T)$ values of all layers.

As shown in FIG. 3A, the dielectric layer 20 includes, for example, a first layer 21, a second layer 22, and a third layer 23. The first layer 21 is disposed between the second layer 22 and the third layer 23. The first layer 21 includes, for example, at least one polymer selected from the group consisting of ethylene-vinyl acetate copolymer, vinyl chloride resin, urethane resin, acrylic resin, acrylic urethane resin, polyethylene, polypropylene, silicone, polyethylene terephthalate, polyethylene naphthalate, polycarbonate, polyimide, and cycloolefin polymer.

In the radio wave absorber 1a, the second layer 22 doubles as a substrate for the impedance matching film 10a. The second layer 22 is, for example, disposed closer to the reflector 30 than the impedance matching film 10a is. As shown in FIG. 3B, the second layer 22 may be disposed farther from the reflector 30 than the impedance matching film 10a is. In this case, the dielectric layer 20 is composed of the first layer 21 and the third layer 23. In this case, the second layer 22 protects the impedance matching film 10a and the dielectric layer 20, and the radio wave absorber 1a has high durability. In this case, for example, the impedance matching film 10a may be in contact with the first layer 21. The material of the second layer 22 is, for example, polyethylene terephthalate (PET), polyethylene naphthalate (PEN), acrylic resin (PMMA), polycarbonate (PC), polyimide (PI), or cycloolefin polymer (COP). Among these, the material of the second layer 22 is desirably PET in terms of the balance among good heat-resistance, dimensional stability, and manufacturing cost.

In the radio wave absorber 1a, the third layer 23 supports, for example, the reflector 30. In this case, the reflector 30 may be produced, for example, by forming a film on the third layer 23 by a method such as sputtering, ion plating, or coating (for example, bar coating). Furthermore, the plurality of openings 11 may be formed by laser processing, etching, or the like. As shown in FIG. 3A, for example, the third layer 23 of the radio wave absorber 1a is disposed closer to the impedance matching film 10a than the reflector 30 is and constitutes a portion of the dielectric layer 20. As shown in FIG. 3C, the third layer 23 may be disposed farther from the impedance matching film 10a than the reflector 30 is. In this case, for example, the reflector 30 is in contact with the first layer 21.

The examples of the material of the second layer 22, for example, can be used as the material of the third layer 23. The material of the third layer 23 may be the same as or different from the material of the second layer 22. The material of the third layer 23 is desirably PET in terms of the balance among good heat-resistance, dimensional stability, and manufacturing cost.

The third layer 23 has a thickness of, for example, 10 to 150 $\mu$m and desirably 15 to 100 $\mu$m. In this case, the third layer 23 has low flexural rigidity, and occurrence of a wrinkle in the third layer 23 or deformation of the third layer 23 can be reduced at the time of formation of the reflector 30. The third layer 23 can be omitted in some cases.

The first layer 21 may be composed of a plurality of layers. The first layer 21 can be composed of a plurality of layers particularly when the first layer 21 is in contact with at least one of the impedance matching film 10a and the reflector 30, as shown in FIGS. 3B and 3C.

The first layer 21 may or may not have adhesiveness. When the first layer 21 has adhesiveness, an adhesive layer may be disposed in contact with at least one of the principal surfaces of the first layer 21 or may be disposed in contact with neither of the principal surfaces of the first layer 21. When the first layer 21 does not have adhesiveness, an adhesive layer is desirably disposed in contact with each of the principal surfaces of the first layer 21. When the dielectric layer 20 includes the second layer 22 which may not have adhesiveness, an adhesive layer may not be disposed in contact with both of the principal surfaces of the second layer 22. When the dielectric layer 20 includes the second layer 22, an adhesive layer can be disposed in contact with one principal surface of the second layer 22. When the dielectric layer 20 includes the third layer 23 which may not have adhesiveness, an adhesive layer may not be disposed in contact with both of the principal surfaces of the third layer 23. In this case, an adhesive layer can be disposed in contact with at least one principal surface of the third layer 23. The adhesive layer includes, for example, a rubber pressure-sensitive adhesive, an acrylic pressure-sensitive adhesive, a silicone pressure-sensitive adhesive, or a urethane pressure-sensitive adhesive.

The radio wave absorber 1a may include at least one of a dielectric loss material and a magnetic loss material. In other words, the radio wave absorber 1a may be a dielectric loss-type radio wave absorber or a magnetic loss-type radio wave absorber. In this case, p/t required of the impedance matching film 10a is likely to be large. The dielectric layer 20 may include at least one of a dielectric loss material and a magnetic loss material. The material of the impedance matching film 10a may be a magnetic material.

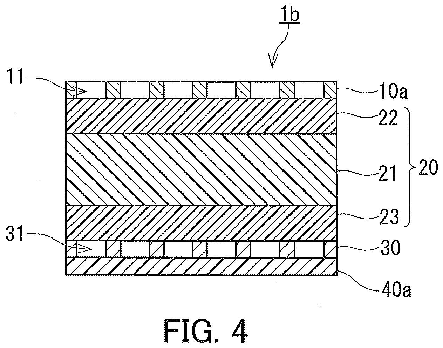

The radio wave absorber 1a can be modified in various respects. For example, the radio wave absorber 1a may be modified to a radio wave absorber 1b shown in FIG. 4. The radio wave absorber 1b is configured in the same manner as the radio wave absorber 1a unless otherwise described. The components of the radio wave absorber 1b that are the same as or correspond to the components of the radio wave absorber 1a are denoted by the same reference characters, and detailed descriptions of such components are omitted. The description given for the radio wave absorber 1a is applicable to the radio wave absorber 1b unless there is a technical inconsistency.

As shown in FIG. 4, the radio wave absorber 1b further includes an adhesive layer 40a. In the radio wave absorber 1b, the reflector 30 is disposed between the dielectric layer 20 and the adhesive layer 40a.

For example, the radio wave absorber 1b can be attached to a given article by bringing the adhesive layer 40a into contact with the article and pressing the radio wave absorber 1 b to the article. A radio wave absorber-attached article can be obtained in this manner.

The adhesive layer 40a includes, for example, a rubber pressure-sensitive adhesive, an acrylic pressure-sensitive adhesive, a silicone pressure-sensitive adhesive, or a urethane pressure-sensitive adhesive. The radio wave absorber 1b may further include a separator (not illustrated). In this case, the separator covers the adhesive layer 40a. The separator is typically a film capable of maintaining the adhesiveness of the adhesive layer 40a while covering the adhesive layer 40a, the film being easily removable from the adhesive layer 40a. The separator is, for example, a film made of a polyester resin such as PET. Removal of the separator exposes the adhesive layer 40a and makes it possible to attach the radio wave absorber 1b to an article.

EXAMPLES

The present invention will be described in more detail by examples. The present invention is not limited to the examples given below. First, methods for evaluation of Examples and Comparative Examples will be described.

[TEM observation]

Samples for observation of cross-sections of imperforate films according to Examples and Comparative Examples and alloy films of alloy film-attached films according to Examples and Comparative Examples were produced using a focused ion beam processing and observation system (manufactured by Hitachi High-Technologies Corporation; product name: FB-2000A). After that, the samples for observation of cross-sections were observed using a field-emission transmission electron microscope (manufactured by Hitachi High-Technologies Corporation; product name: HF-2000), and thicknesses of the imperforate films according to Examples and Comparative Examples were measured. Thicknesses of the alloy films of the alloy film-attached films according to Examples and Comparative Examples were measured in the same manner. The results are shown in Table 1.

[Specific resistance]

Sheet resistances of the imperforate films according to Examples and Comparative Examples were measured by an eddy current method according to JIS Z 2316 using a non-contact resistance measurement apparatus (manufactured by NAPSON CORPORATION; product name: NC-80MAP). A product of the thickness and sheet resistance of each of the imperforate films according to Examples and Comparative Examples measured in the above manner was obtained to determine a specific resistance of the material of the imperforate film. The specific resistance of the material of each imperforate film was regarded as a specific resistance of the material of the alloy film of each of the alloy film-attached films according to Examples and Comparative Examples. The results are shown in Table 1.

[Radio wave absorption performance]

A radio wave having a frequency of 1 to 90 GHz was incident on samples according to Examples and Comparative Examples at an incident angle of 0°, and an absolute value of a reflection amount at each frequency was determined for each sample according to JIS R 1679: 2007. For each sample, the largest absolute value of the reflection amount, a frequency (absorption peak frequency) at which the largest absolute value was shown, and a frequency range in which the absolute value of the reflection amount was 20 dB or more were determined.

<Example 1>

An Al-Si alloy film was formed on a PET film by DC magnetron sputtering using Al (aluminum) and Si (silicon) as target materials and argon gas as a process gas. In the DC magnetron sputtering, discharging involving the Al (aluminum) target material and discharging involving the Si (silicon) target material were simultaneously performed. In this manner, an imperforate film according to Example 1 was formed on the PET film. The material of the imperforate film according to Example 1 had a specific resistance of $1.0 \times 10^{-4}$ $\Omega$•cm. Next, a plurality of square openings were formed in the imperforate film according to Example 1 using a laser pattern metal processing machine to obtain an alloy film-attached film according to Example 1. The maximum size of the opening was 127 $\mu$m and the minimum of a distance between the openings adjacent to each other was 10 $\mu$m in plan view. The plurality of openings were formed such that centers thereof made a square lattice in plan view.

DC magnetron sputtering was performed using, as a target material, an ITO including 10 weight% of $SnO_2$ and argon and oxygen as process gasses to form an ITO film on the PET film. After that, annealing treatment of the ITO film was performed at a temperature of 150°C for one hour to turn the ITO into a polycrystal and obtain a reflector-attached film. A reflector of the reflector-attached film had a sheet resistance of 20 $\Omega$/□. Next, an acrylic resin having a relative permittivity of 2.6 was shaped to a thickness of 615 $\mu$m to obtain an acrylic resin layer A. The alloy film-attached film according to Example 1 was placed over the acrylic resin layer A such that the alloy film of the alloy film-attached film according to Example 1 was in contact with the acrylic resin layer A. Next, the reflector-attached film was placed over the acrylic resin layer A such that a Cu film of the reflector-attached film was in contact with the acrylic resin layer A. A sample according to Example 1 was obtained in this manner.

<Example 2>

An imperforate film according to Example 2 was formed on a PET film and an alloy film-attached film according to Example 2 was obtained in the same manner as in Example 1, except for the following. A ratio of discharge power in the discharging involving the Si (silicon) target material to discharge power in the discharging involving the Al (aluminum) target material was adjusted in the DC magnetron sputtering so that the material of the imperforate film according to Example 2 would have a specific resistance of $1.4 \times 10^{-3}$ $\Omega$•cm. DC magnetron sputtering conditions were also adjusted so that the alloy film of the alloy film-attached film according to Example 2 would have a thickness of 350 nm. A plurality of square openings were formed in the imperforate film according to Example 2 using a laser pattern metal processing machine to obtain the alloy film-attached film according to Example 2. The maximum size of the opening was 127 $\mu$m and the minimum of a distance between the openings adjacent to each other was 10 $\mu$m in plan view. The plurality of openings were formed such that centers thereof made a square lattice in plan view.

A sample according to Example 2 was obtained in the same manner as in Example 1, except that the alloy film-attached film according to Example 2 was used instead of the alloy film-attached film according to Example 1.

<Example 3>

An imperforate film according to Example 3 was formed on a PET film and an alloy film-attached film according to Example 3 was obtained in the same manner as in Example 1, except for the following. A ratio of discharge power in the discharging involving the Si (silicon) target material to discharge power in the discharging involving the Al (aluminum) target material was adjusted in the DC magnetron sputtering so that the material of the imperforate film according to Example 3 would have a specific resistance of $1.0 \times 10^{-5}$ $\Omega \cdot$cm. DC magnetron sputtering conditions were also adjusted so that the alloy film of the alloy film-attached film according to Example 3 would have a thickness of 5 nm. A plurality of square openings were formed in the imperforate film according to Example 3 using a laser pattern metal processing machine to obtain the alloy film-attached film according to Example 3. The maximum size of the opening was 269 $\mu$m and the minimum of a distance between the openings adjacent to each other was 10 $\mu$m in plan view. The plurality of openings were formed such that centers thereof made a square lattice in plan view.

A sample according to Example 3 was obtained in the same manner as in Example 1, except that the alloy film-attached film according to Example 3 was used instead of the alloy film-attached film according to Example 1 and an acrylic resin layer B obtained by shaping an acrylic resin having a relative permittivity of 2.6 to a thickness of 630 $\mu$m was used instead of the acrylic resin layer A.

<Example 4>

An imperforate film according to Example 4 was formed on a PET film and an alloy film-attached film according to Example 4 was obtained in the same manner as in Example 1, except for the following. A ratio of discharge power in the discharging involving the Si (silicon) target material to discharge power in the discharging involving the Al (aluminum) target material was adjusted in the DC magnetron sputtering so that the material of the imperforate film according to Example 4 would have a specific resistance of $5.0 \times 10^{-4}$ $\Omega \cdot$cm. DC magnetron sputtering conditions were also adjusted so that the alloy film of the alloy film-attached film according to Example 4 would have a thickness of 25 nm. A plurality of square openings were formed in the imperforate film according to Example 4 using a laser pattern metal processing machine to obtain the alloy film-attached film according to Example 4. The maximum size of the opening was 35 $\mu$m and the minimum of a distance between the openings adjacent to each other was 10 $\mu$m in plan view. The plurality of openings were formed such that centers thereof made a square lattice in plan view.

A sample according to Example 4 was obtained in the same manner as in Example 1, except that the alloy film-attached film according to Example 4 was used instead of the alloy film-attached film according to Example 1 and an acrylic resin layer C obtained by shaping an acrylic resin having a relative permittivity of 2.6 to a thickness of 605 $\mu$m was used instead of the acrylic resin layer A.

<Example 5>

An imperforate film according to Example 5 was formed on a PET film in the same manner as in Example 1. A plurality of square openings were formed in the imperforate film according to Example 5 using a laser pattern metal processing machine to obtain the alloy film-attached film according to Example 5. The maximum size of the opening was 14 $\mu$m and the minimum of a distance between the openings adjacent to each other was 1 $\mu$m in plan view. The plurality of openings were formed such that centers thereof made a square lattice in plan view.

A sample according to Example 5 was obtained in the same manner as in Example 1, except that the alloy film-attached film according to Example 5 was used instead of the alloy film-attached film according to Example 1 and an acrylic resin layer C was used instead of the acrylic resin layer A.

<Example 6>

An imperforate film according to Example 6 was formed on a PET film and an alloy film-attached film according to Example 6 was obtained in the same manner as in Example 1, except for the following. A ratio of discharge power in the discharging involving the Si (silicon) target material to discharge power in the discharging involving the Al (aluminum) target material was adjusted in the DC magnetron sputtering so that the material of the imperforate film according to Example 6 would have a specific resistance of $7.8 \times 10^{-5}$ $\Omega \cdot$cm. DC magnetron sputtering conditions were also adjusted so that the alloy film of the alloy film-attached film according to Example 4 would have a thickness of 25 nm. A plurality of square openings were formed in the imperforate film according to Example 6 using a laser pattern metal processing machine to obtain the alloy film-attached film according to Example 6. The maximum size of the opening was 707 $\mu$m and the minimum of a distance between the openings adjacent to each other was 50 $\mu$m in plan view. The plurality of openings were formed such that centers thereof made a square lattice in plan view.

A sample according to Example 6 was obtained in the same manner as in Example 1, except that the alloy film-attached film according to Example 6 was used instead of the alloy film-attached film according to Example 1 and an acrylic resin layer D obtained by shaping an acrylic resin having a relative permittivity of 2.6 to a thickness of 650 $\mu$m was used instead of the acrylic resin layer A.

<Example 7>

An imperforate film according to Example 7 was formed on a PET film in the same manner as in Example 1. A plurality of square openings were formed in the imperforate film according to Example 7 using a laser pattern metal processing machine to obtain the alloy film-attached film according to Example 7. The maximum size of the opening was 3536 $\mu$m and the minimum of a distance between the openings adjacent to each other was 250 $\mu$m in plan view. The plurality of openings were formed such that centers thereof made a square lattice in plan view.

An acrylic resin having a relative permittivity of 2.6 was shaped to a thickness of 18500 $\mu$m to obtain an acrylic resin layer E. A sample according to Example 7 was obtained in the same manner as in Example 1, except that the alloy film-attached film according to Example 7 was used instead of the alloy film-attached film according to Example 1 and the acrylic resin layer E was used instead of the acrylic resin layer A.

<Example 8>

An imperforate film according to Example 10 was formed on a PET film and an alloy film-attached film according to Example 10 was obtained in the same manner as in Example 1, except for the following. A ratio of discharge power in the discharging involving the Si (silicon) target material to discharge power in the discharging involving the Al (aluminum) target material was adjusted in the DC magnetron sputtering so that the material of the imperforate film according to Example 10 would have a specific resistance of $1.0 \times 10^{-5}$ $\Omega$•cm. DC magnetron sputtering conditions were also adjusted so that the alloy film of the alloy film-attached film according to Example 10 would have a thickness of 25 nm. A plurality of square openings were formed in the imperforate film according to Example 10 using a laser pattern metal processing machine to obtain the alloy film-attached film according to Example 10. The maximum size of the opening was 47192 $\mu$m and the minimum of a distance between the openings adjacent to each other was 640 $\mu$m in plan view. The plurality of openings were formed such that centers thereof made a square lattice in plan view.

An acrylic resin having a relative permittivity of 2.6 was shaped to a thickness of 51300 $\mu$m to obtain an acrylic resin layer F. A sample according to Example 8 was obtained in the same manner as in Example 1, except that the alloy film-attached film according to Example 8 was used instead of the alloy film-attached film according to Example 1 and the acrylic resin layer F was used instead of the acrylic resin layer A.

<Comparative Example 1>

An imperforate film according to Comparative Example 1 was formed on a PET film and an alloy film-attached film according to Comparative Example 1 was obtained in the same manner as in Example 1, except for the following. A ratio of discharge power in the discharging involving the Si (silicon) target material to discharge power in the discharging involving the Al (aluminum) target material was adjusted in the DC magnetron sputtering so that the material of the imperforate film according to Comparative Example 1 would have a specific resistance of $1.0 \times 10^{-3}$ $\Omega$•cm. DC magnetron sputtering conditions were also adjusted so that the alloy film of the alloy film-attached film according to Comparative Example 1 would have a thickness of 25 nm. A plurality of square openings were formed in the imperforate film according to Comparative Example 1 using a laser pattern metal processing machine to obtain the alloy film-attached film according to Comparative Example 1. The maximum size of the opening was 1.4 $\mu$m and the minimum of a distance between the openings adjacent to each other was 10 $\mu$m in plan view. The plurality of openings were formed such that centers thereof made a square lattice in plan view.

A sample according to Comparative Example 1 was obtained in the same manner as in Example 1, except that the alloy film-attached film according to Comparative Example 1 was used instead of the alloy film-attached film according to Example 1.

<Comparative Example 2>

An imperforate film according to Comparative Example 1 was formed on a PET film and an alloy film-attached film according to Comparative Example 1 was obtained in the same manner as in Example 1, except for the following. A ratio of discharge power in the discharging involving the Si (silicon) target material to discharge power in the discharging involving the Al (aluminum) target material was adjusted in the DC magnetron sputtering so that the material of the imperforate film according to Comparative Example 1 would have a specific resistance of $1.0 \times 10^{-6}$ $\Omega$•cm. DC magnetron sputtering conditions were also adjusted so that the alloy film of the alloy film-attached film according to Comparative Example 1 would have a thickness of 25 nm. A plurality of square openings were formed in the imperforate film according to Comparative Example 1 using a laser pattern metal processing machine to obtain the alloy film-attached film according to Comparative Example 1. The maximum size of the opening was 707 $\mu$m and the minimum of a distance between the openings adjacent to each other was 10 $\mu$m in plan view. The plurality of openings were formed such that centers thereof made a square lattice in plan view.

A sample according to Comparative Example 2 was obtained in the same manner as in Example 1, except that the alloy film-attached film according to Comparative Example 2 was used instead of the alloy film-attached film according to Example 1.

As shown in Table 1, the samples according to Examples 1 to 8 exhibited high absorption performance for the radio waves having the given frequencies, which reveals that desirable impedance matching is performed by means of the alloy films of the alloy film-attached films according to Examples. On the other hand, it is hard to say that the samples according to Comparative Examples 1 and 2 exhibited high absorption performance for the radio waves having the given frequencies, which indicates that it is hard to perform impedance matching by means of the alloy films of the alloy film-attached films according to Comparative Examples. These indicate that the p/t value of the alloy film within the predetermined value range is advantageous in terms of impedance matching. The alloy films of the alloy film-attached films according to Examples had high opening proportion and transparency.

[Table 1]

| | Specific resistance ρ [Ω·cm] | Thickness t of alloy film [nm] | ρ/t [Ω/□] | Maximum size of opening [μm] | Minimum of distance between openings [μm] | Opening proportion [%] | Absorption peak frequency [GHz] | Largest absolute value \|R\| of reflection amount [dB] | Range in which \|R\| ≥ 20 dB is established [GHz] | Thickness of dielectric layer [μm] |
|---|---|---|---|---|---|---|---|---|---|---|
| Example 1 | $10 \times 10^{-4}$ | 25 | 40 | 127 | 10 | 81 | 77 | 57 | 12 | 615 |
| Example 2 | $1.4 \times 10^{-3}$ | 350 | 40 | 127 | 10 | 81 | 77 | 37 | 11.8 | 615 |
| Example 3 | $10 \times 10^{-5}$ | 5 | 20 | 269 | 10 | 90 | 77 | 34 | 11.6 | 630 |
| Example 4 | $5.0 \times 10^{-4}$ | 25 | 200 | 35 | 10 | 51 | 77 | 33 | 12.1 | 605 |
| Example 5 | $10 \times 10^{-4}$ | 25 | 40 | 14 | 1 | 83 | 77 | 32 | 11.5 | 605 |
| Example 6 | $7.8 \times 10^{-5}$ | 25 | 31 | 707 | 50 | 83 | 77 | 34 | 11.2 | 650 |
| Example 7 | $10 \times 10^{-4}$ | 25 | 40 | 3536 | 250 | 83 | 2.5 | 28 | 0.4 | 18500 |
| Example 8 | $10 \times 10^{-5}$ | 25 | 4 | 47192 | 640 | 96 | 1.2 | 36 | 0.1 | 51300 |
| Comparative Example 1 | $10 \times 10^{-3}$ | 25 | 400 | 1.4 | 10 | 1 | 77 | 29 | 11.1 | 605 |
| Comparative Example 2 | $10 \times 10^{-6}$ | 25 | 0.4 | 707 | 10 | 96 | 77 | 5.8 | Less than 0.1 | 970 |

**Claims**

1. An impedance matching film, comprising: a plurality of openings regularly arranged along a principal surface of the impedance matching film, wherein
a value obtained by dividing a specific resistance of a material of the impedance matching film by a thickness of the impedance matching film is 1 to 300 $\Omega/\square$.

2. The impedance matching film according to claim 1, wherein a maximum size of the opening on the principal surface is $7.5 \times 10^4$ $\mu$m or less.

3. The impedance matching film according to claim 1 or 2, wherein a minimum of a distance between the openings adjacent to each other is 0.1 to 650 $\mu$m.

4. The impedance matching film according to any one of claims 1 to 3, wherein the thickness is 5 to 500 nm.

5. The impedance matching film according to any one of claims 1 to 4, wherein the specific resistance is $5 \times 10^{-6}$ to $2 \times 10^{-3}$ $\Omega\cdot$cm.

6. A radio wave absorber, comprising:

the impedance matching film according to any one of claims 1 to 5;
a reflector that reflects a radio wave; and
a dielectric layer disposed between the impedance matching film and the reflector in a thickness direction of the impedance matching film.

7. The radio wave absorber according to claim 6, wherein

the maximum size of the opening is 1/4 or less of an absorption peak wavelength, and
the absorption peak wavelength is a radio wavelength at which an absolute value of a reflection amount measured for the radio wave absorber according to Japanese Industrial Standards (JIS) R 1679: 2007 is largest.

8. The radio wave absorber according to claim 6 or 7, being configured to perform impedance matching for a radio wave having a frequency of 1 GHz or more.

9. The radio wave absorber according to claim 7 or 8, wherein the reflector is a transparent conductive film.

10. The radio wave absorber according to claim 9, wherein the transparent conductive film has a plurality of openings regularly arranged along a principal surface of the transparent conductive film.

15

D2

D1 — 10a

10f

11

IB — IB

## FIG. 1A

15a

11  10f

t

10a

22

## FIG. 1B

D2

10b

D1 — 10f

11

## FIG. 2A

D1

10c
10f
11

D2

FIG. 2B

D1

10d
10f

D2

11

FIG. 2C

1a

10a
22
21 } 20
23
31
30

FIG. 3A

1a

22
11
10a
21
20
23
31
30

FIG. 3B

1a

11
10a
22
20
21
30
31
23

FIG. 3C

FIG. 4

## INTERNATIONAL SEARCH REPORT

International application No.

PCT/JP2020/031879

A. CLASSIFICATION OF SUBJECT MATTER
H05K 9/00(2006.01)i; B32B 7/025(2019.01)i
FI: H05K9/00 M; H05K9/00 V; B32B7/025
According to International Patent Classification (IPC) or to both national classification and IPC

B. FIELDS SEARCHED

Minimum documentation searched (classification system followed by classification symbols)
H05K9/00; B32B7/025

| Documentation searched other than minimum documentation to the extent that such documents are included in the fields searched | |
|---|---|
| Published examined utility model applications of Japan | 1922-1996 |
| Published unexamined utility model applications of Japan | 1971-2020 |
| Registered utility model specifications of Japan | 1996-2020 |
| Published registered utility model applications of Japan | 1994-2020 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2011-066094 A (NITTA CORP.) 31 March 2011 (2011-03-31) paragraphs [0108]-[0133], fig. 1-2 | 1-3, 6-7, 9-10<br>4-5, 8 |
| Y | WO 2019/132027 A1 (NITTO DENKO CORP.) 04 July 2019 (2019-07-04) paragraphs [0027]-[0029] | 4-5, 8 |
| Y | JP 2019-004006 A (NITTO DENKO CORP.) 10 January 2019 (2019-01-10) paragraphs [0018]-[0020], [0066] | 4-5, 8 |
| A | WO 2004/091049 A1 (CHANG SUNG CORPORATION) 21 October 2004 (2004-10-21) page 5, line 22 to page 5, line 29, fig. 1A | 1-10 |

☐ Further documents are listed in the continuation of Box C.   ☒ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 15 October 2020 (15.10.2020) | 27 October 2020 (27.10.2020) |

| Name and mailing address of the ISA/<br>Japan Patent Office<br>3-4-3, Kasumigaseki, Chiyoda-ku,<br>Tokyo 100-8915, Japan | Authorized officer<br><br>Telephone No. |
|---|---|

Form PCT/ISA/210 (second sheet) (January 2015)

INTERNATIONAL SEARCH REPORT
Information on patent family members

International application no.

PCT/JP2020/031879

| Patent Documents referred in the Report | Publication Date | Patent Family | Publication Date |
|---|---|---|---|
| JP 2011-066094 A | 31 Mar. 2011 | (Family: none) | |
| WO 2019/132027 A1 | 04 Jul. 2019 | TW 201933980 A | |
| JP 2019-004006 A | 10 Jan. 2019 | CN 110771273 A | |
| | | KR 10-2020-0018425 A | |
| WO 2004/091049 A1 | 21 Oct. 2004 | KR 10-0591909 B1 | |

Form PCT/ISA/210 (patent family annex) (January 2015)

**EP 4 030 880 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006179671 A